# EUROPEAN PATENT SPECIFICATION

(11) **EP 0 364 139 B1**
(45) Date of publication and mention of the grant of the patent: **23.02.1994**
(21) Application number: 89309982.0
(22) Date of filing: 29.09.1989
(51) Int. Cl.: C30B 25/18, H01L 21/20

(54) **Crystal article and method for forming same**
Gegenstand aus Kristall und Verfahren zu seiner Herstellung
Objet en cristal et procédé pour sa fabrication

(30) Priority: 02.10.1988 JP 247820/88; 29.09.1989 JP 255523/89
(43) Date of publication of application: 18.04.1990
(73) Proprietor: CANON KABUSHIKI KAISHA, Tokyo (JP)
(72) Inventor: Sato, Nobuhiko, Atsugi-shi Kanagawa-ken (JP)
(74) Representative: Beresford, Keith Denis Lewis

(56) References cited:
- EP-A- 0 284 433
- US-A- 4 557 794

## Description

This invention relates to a crystal article and a method for forming the same, particularly to a crystal article having a plurality of single crystals formed on a deposition surface at defined positions, the positions of grain boundaries formed where the single crystals mutually contact each other and the sizes of the single crystals being controlled, and a method for forming the same.

The present invention is applicable to single crystals to be utilised for production of, for example, electronic elements such as semiconductor integrated circuits, magnetic circuits, etc., optical elements, magnetic elements, piezoelectric elements, or surface acoustic elements, etc.

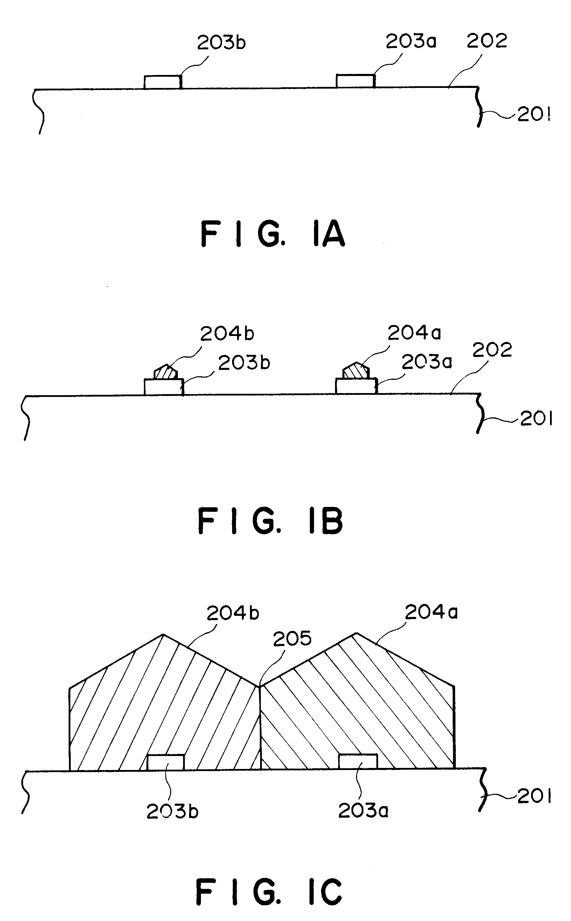

In the field of SOI techniques used to grow a plurality of single crystals on an insulating substrate, there has been proposed, for example, a method based on selective nucleation depending on the difference in nucleation density between the surface materials (T. Yonehara et al., Extended Abstracts of the 19th Conference on Solid State Devices and Materials, Tokyo, 1987, pp. 191-194). The crystal formation method is to be described by referring to Figs. 1A to 1C. First, as shown in Fig. 1A, on a substrate 201 having a surface 202 with small nucleation density are arranged regions 203a, 203b having surfaces with sufficiently larger nucleation density than the surface 202 with a diameter of a and an interval b . If a predetermined crystal formation treatment is applied on the substrate, crystal nuclei of the deposited product will be generated only on the surfaces of the regions 203a, 203b, and never on the surface 202. Accordingly, the surfaces of the regions 203a, 203b are called nucleation surfaces (S_{NDL}) and the surface 202 non-nucleation surface (S_{NDS}). If the nuclei generated on the nucleation surfaces 203a, 203b are further permitted to grow, they become single crystals 204a, 204b (see Figs. 1B, 1C), growing onto the non-nucleation surface 202 beyond the regions of the nucleation surfaces 203a, 203b, until contacting the single crystal 204b grown from the adjacent nucleation surface 203b to form a grain boundary 205. In the crystal formation method of the prior art, there have been reported an example, in which the nucleation surfaces 203a, 203b are formed of amorphous Si₃N₄, the non-nucleation surface 202 formed of SiO₂, and a plurality of Si single crystals according to the CVD method (see the above essay), and an example, in which the non-nucleation surface 202 is formed of Si0₂, the region which becomes the nucleation surface 203a is formed by injecting Si ions into the non-nucleation surface 202 with a focused ion beam, and subsequently a plurality of Si single crystals are formed according to the CVD method (The 35th Associated Lectures Related to Applied Physics, 1988, 28p-M-9, p 584 Abstract of paper entitled "SENTAXY (Selective Nucleaction Epitaxy) by F 1B(2)" by H. Kumomi et al. (Japanese text).

However, when these single crystals are formed in lattice points in a plurality of crystal grains according to the crystal formation method with controlled formation positions thereof, there may sometimes occur the problems as shown below, and in that case, problems may sometimes occur in forming a semiconductor integrated circuit or other electronic or optical elements.

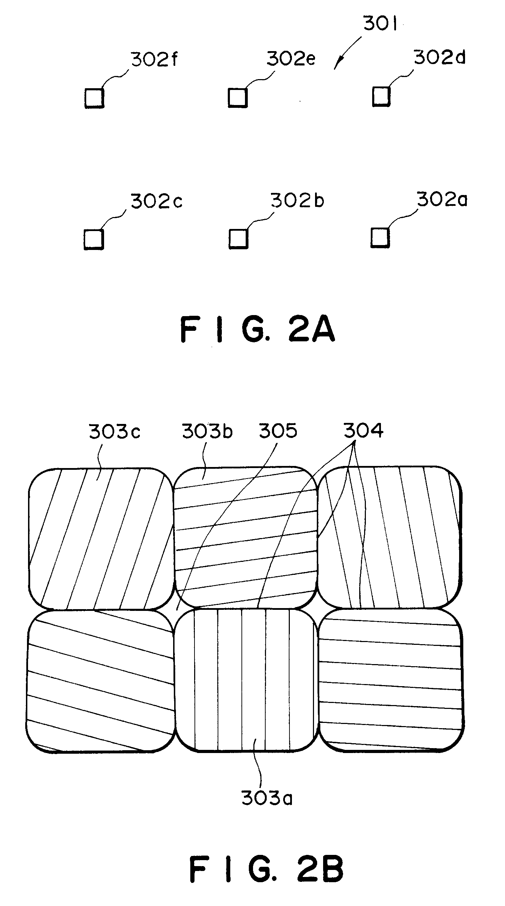

More specifically, when the nucleation surfaces 203a, 203b shown in Figs. 1A-1C are arranged in lattice points on the non-nucleation surface 301 as shown in Fig. 2A, and the crystal growth treatment is applied thereon, the single crystals grown from the nucleation surfaces which are the nearest nucleation surfaces to the nucleation surface 302b contact the single crystal 303a to form grain boundaries 304. However, at the central portion in the interval from the second nearest nucleation surface 303c relative to the nucleation surface 302b, the single crystals cannot completely contact each other, whereby a void 305 may be sometimes generated [Fig. 2B]. This void 305 may be extinguished by close contact between the upper portions of the single crystals by elongating the crystal growth treatment time, but when the upper portions of the single crystals are removed to be flattened by etching or polishing so as to form a semiconductor integrated circuit, or other elements, etc., the void 305 may be sometimes observed to appear.

On the void 305, it is impossible to form an element utilizing the characteristics of the single crystal such as MOS transistors, diodes, etc. Further, even when a thin film intended to wiring is desired to be formed on the void 305, since the film thickness of the crystal grain after flattening is some 100 Å or higher, generally about 1 µm from the demand in formation of the element, and from the point of controllabillty of flattening, when the thickness of the single crystal 303a surpasses this thickness, there also occurred sometimes wire breaking at the stepped difference portion between the void 305 and the single crystal 303a. Accordingly, when the surface portions of a plurality of single crystals formed according to the crystal formation method in which these single crystals are formed with controlled positions thereof are flattened by cutting, and a semiconductor integrated circuit or other elements, etc. are formed thereon, since the active region is formed by avoiding the void 305, the circuit constitution or the element constitution is restricted to be lowered in degree of freedom in design, or troubles may sometimes occur in miniaturisation of the element.

The present invention provides a remedy.

In accordance with the present invention there is provided a method for forming a plurality of single-crystals on a substrate, which method comprises the steps of:
providing a substrate having a plurality of nucleation surfaces which serve as crystal growth origination points, and a non-nucleation surface having a nucleation density smaller than the nucleation density of the nucleation surfaces; and
applying to the substrate a crystal growth treatment for a time long enough for adjacent crystals which are grown from the crystal growth origination points to contact each other,
which method is characterised in that
at a predetermined position of a void which otherwise would be formed between said single-crystals, a void generation preventive body for filling said void is prearranged, the surface of which has a nucleation density which is smaller by at least 10² fold than the nucleation density of each nucleation surface.

As in the reported state of the art methods the method aforesaid produces single crystals of defined size at defined locations. Advantageously where hitherto a void would have occurred between adjoining crystals, the void area is filled by the prearranged void generation preventive body. When subsequently the crystals are etched by etching or polishing, a plane surface with no indentations can be achieved. Integrated circuit metallisation can then be performed satisfactorily. The problems of metallisation in the presence of stepped structure and interconnect fracture are thus obviated. This then leads to improvements in yield. The degree of freedom in circuit design is also enhanced and a higher integration can be achieved.
Figs. 1A to 1C are schematic illustrations for explaining the steps of a method for forming crystal articles according to the prior art;
Figs. 2A and 2B are schematic illustrations for further explaining the steps of the method for forming crystal articles according to the prior art shown in Figs. 1A to 1C as the top views; and
Figs. 3A to 3C are schematic illustrations for explaining the steps of a method embodying the present invention.

In the method of forming a plurality of single crystals on a substrate by defining their positions from the origination points of crystal growth and controlling the position of the grain boundaries formed where the single crystals contact each other and the size of the single crystals (the selective growth method), the positions and sizes of the voids are also defined. Accordingly, in the present invention, at the positions where voids are to be formed, prior to the crystal growth treatment, void generation preventive bodies are arranged, which are suited for the sizes and shapes of the voids.

Here, the origination points for crystal growth should have greater nucleation density for the material of the crystal to be formed, and desirably be formed of a material with a nucleation density which is greater by at least 10²-fold than the nucleation density of the non-nucleation surface of the substrate surface, more preferably by at least 10³-fold.

The void generation preventive body is preferably constituted of a material which has a nucleation density at its surface sufficiently small at least to the same extent as the non-nucleation surface and can sufficiently inhibit nucleation at the surface thereof during crystal growth.

By applying a crystal formation treatment on the substrate applied with the treatment necessary for control of the position of the crystals and provided with void generation preventive bodies, the single crystals grown with their formation positions controlled will contact the adjacent single crystals forming grain boundaries, and also due to the presence of the void generation preventive bodies at the portions where voids would have been formed in the prior art, will contact the void generation preventive bodies at the void generation areas, whereby no void between single crystals as seen in the prior art is generated.

Further, according to the present invention, since a group of flat single crystals, formed of single crystals in contact at grain boundaries are obtained, in addition to acceleration of the actuation by formation of active elements such as transistors, etc., it is also possible to effect further higher densitification of the element constitution by forming passive elements or wirings such as diodes, transistors, etc., at the portions crossing the grain boundaries.

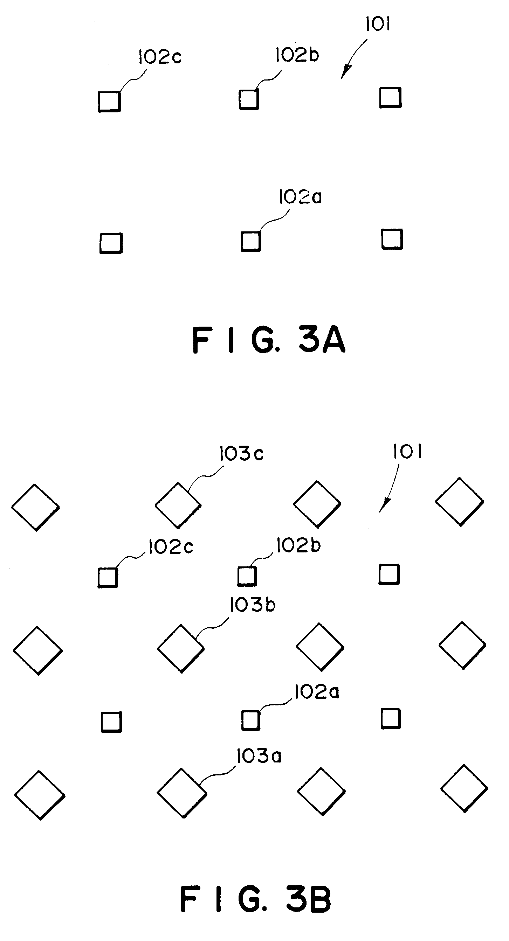

Referring now to Figs. 3A-3C, the crystal article and the method for formation thereof according to the present invention are to be described.

On a base material 101, the treatment necessary for controlling the position for formation of the crystal is applied. That is, a substrate having origination points for crystal growth is formed. For example, there may be also employed a method in which a substrate is used having a plurality of fine single crystal grains 102a, 102b, 102c arranged at desired positions on the surface of the base material 101 which is to be the non-nucleation surface (see Figs. 3A).

Alternatively, for example, it is also possible to use a substrate having a non-nucleation surface and a plurality of nucleation surfaces provided at desired positions and having an area sufficiently small to result in the formation of only a single nucleus from which a single crystal is grown on the base material 101.

As the base material 101, any of materials suited for subsequent treatments such as Si wafer, quartz glass, ceramics, etc. may be available.

As the method of forming the substrate having the nucleation surface arranged thereon, a material with greater nucleation density may be arranged finely divided or fine openings may be provided in a layer of a material with small nucleation density covering over the material with great nucleation density to have the material with great density exposed, or alternatively it may be also formed by ion implanting ions which elevate the nucleation density of the non-nucleation surface into fine regions of the non-nucleation surface.

The surface area of the nucleation surface for forming a single crystal with good selectivity may be preferably 16 µm² or less, more preferably 4 µm² or less, optimally 1 µm² or less.

As preferable examples of the material of the non-nucleation surface, non-single crystalline inorganic materials such as quartz glass, thermally oxidized silicon, silicon nitride, alumina, etc. may be included.

As preferable examples of the material of the nucleation surface, materials such as amorphous silicon, silicon nitride, etc. may be included.

Also, when forming single crystal grains as the origination point for crystal growth by applying thermal treatment to a non-single crystalline material, a suitable impurity such as P, B, As, etc. may be also added for promoting single crystal formation from the non-single crystalline material. Its amount added may be preferably 1 x 10²⁰ atoms/cm³, more preferably 7.5 x 10²⁰ atoms/cm³.

At the positions where voids are formed when crystal growth treatment is applied on the substrate having origination points for crystal growth, void generation preventive bodies 103a, 103b, 103c are arranged [Fig. 3B]. The void generation preventive bodies 103a, 103b, 103c are to be described in detail below.

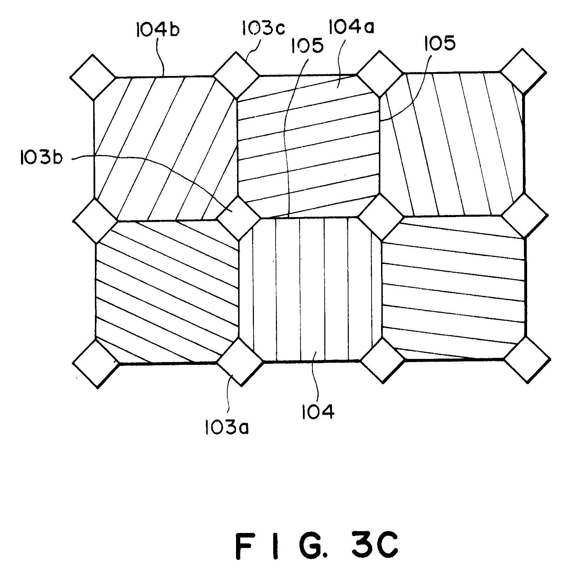

Subsequently, when the crystal growth treatment is applied on the substrate 101 shown in Fig. 3B, a single crystal 104 grows to contact the adjacent single crystal grain 104a to form a grain boundary 105, and also contacts the void generation preventive bodies 103a, 103b [Fig. 3C]. Here, the single crystal 104 to be grown may be a crystal of Si, Ge, GaAs, InP, etc. or any other one. Also, the order of the step of providing the crystal growth origination point and the step of providing the void generation preventive body as described above may be reversed. That is, it is also possible to arrange previously the void generation preventive bodies on the substrate and then applying the treatment necessary for controlling the positions at which the crystals are formed.

Preferable examples of the treatment of the crystal growth treatment applicable in the present invention may include a gas phase method such as normal pressure CVD, reduced pressure CVD, plasma CVD, optical CVD, sputtering etc., and the liquid phase method such as the gradual cooling method, the temperature gradient method, etc.

Next, the void generation preventive body is to be described in detail.

The void generation preventive body is required to have a sufficiently low nucleation density to the same extent as the non-nucleation surface, when considering the nucleation density at its surface so that no nucleus may be formed on the void generation preventive body surface during the crystal formation treatment. Specifically, it is required to be 10²-fold or less of the nucleation density of the nucleation surface, desirably substantially the same as the non-nucleation surface or less.

As the material constituting the void generation preventive body, those preferably used in the present invention in view of the above demand may include such substances as silicon dioxide, silicon nitride, tin oxide or indium oxide or non-stoichiometric compound variants thereof, etc.

The shape of the void generation preventive body may be in conformity with the shape of the void formed according to the prior art method. For example, when the nucleation surfaces which are origination points for crystal growth are arranged in lattice points, the voids are formed substantially in square shapes and therefore the void generation preventive bodies should preferably be formed in square shapes as the shape observed from above so as to match the shapes of the voids.

The shape of the void generation preventive body as observed from above should be preferably made a shape having a plane substantially vertical toward the adjacent origination point for crystal growth.

When an active element is formed by use of the crystal article as described above, the surface portion of the single crystal is flattened by etching polishing, etc., and a semiconductor circuit or various elements are formed at the flat portion formed. If the thickness of the single crystal after flattening is made t, according to an isotropic flattening treatment with the thickness of the void generation preventive body being as t or more, the surface portions of the single crystals and the void generation preventive body are cut at the same time to obtain the desired thickness t.

On the other hand, according to a flattening treatment which cuts selectively the surface portion of the single crystal relative to the void generation preventive body, the thickness of the void generation preventive body is made to be equal to or similar to t and used for the end point detection of the flattening treatment.

The method for forming the void generation preventive body as described above may be any method, but, for example, the following method may be employed. First, a thin film comprising the void generation preventive body is deposited according to conventional thin film deposition method (e.g. any of thermal CVD, APCVD, LPCVD, plasma CVD, optical CVD, sputtering, etc.), and then the desired portion may be left to remain as the void generation preventive body with removal of the other portions according to conventional photolithography.

In the following, Examples in which a plurality of Si single crystals are formed on a substrate according to the present invention are shown.

### Example 1

First, using a Si (100) wafer substrate as the base material, an amorphous silicon dioxide film with a thickness of about 1000 Å is formed by a thermal oxidation method. Next, employing a conventional reduced pressure CVD method using starting gases of SiH₂Cl₂ and NH₃, a silicon nitride film is deposited to 30 nm (300 Å) on the silicon dioxide film. Next, according to conventional resist process, a silicon nitride film was arranged in square shapes with one side of 2 µm in lattices with intervals of 80 µm, and a patterning treatment is effected at other regions so that the silicon dioxide surface is exposed. Etching is then performed using an RIE method (reactive ion etching method) to remove unnecessary portions of the silicon nitride film.

Next, according to a normal pressure CVD method, a silicon dioxide film is further deposited to 50 nm (5000 Å) on the substrate treated as described above. The silicon dioxide film is subjected to a patterning treatment by a conventional resist process so that a square with one side of 10 µm is formed at a centre portion of a square constituted by areas of silicon nitride film arranged at four lattice points so as to be slanted at 45^{o} with respect to the square constituted of the areas of silicon nitride film. This is effected by RIE to remove unnecessary portions of the silicon dioxide film to provide void generation preventive bodies 103a, 103b, 103c, ... (areas of silicon dioxide oxide film) (see Fig. 3B).

On the treated substrate Si is deposited by a CVD method. The deposition conditions used are as follows:
Gases used (flow rate ratio): SiH₂Cl₂/HCl/H₂= 0.53/1.6/100.0 (slm)
Substrate temperature and Pressure: 1000^{o}C, 2.00 x 10⁴ Pa (150 Torr)
Deposition time: 90 min.

As a result, with the centres of all the nucleation surfaces arranged at lattice points as the crystal growth origination points, Si single crystals with a grain size of about 80 µm are grown, which contact the single crystals grown from the adjacent nucleation surfaces at substantially the intermediate position between the adjacent nucleation surfaces to form a grain boundary. Further, the Si single crystals also contact the silicon dioxide films (void generation preventive bodies) 103a, 103b, 103c..., and the respective single crystals are found to be grown up to the position higher than the surface of the silicon dioxide film (void generation preventive body) at many places. Further, when polishing is effected on the surface portions of the respective Si single crystals by selective polishing e.g. as described in the Research Report SSD 86-63 of Japanese Society of Electrical Communication, polishing is completed with the areas of silicon dioxide oxide film 103a, 103b, 103c ... as an etch stop. When the substrate thus treated is again subjected to surface observation by an optical microscope, a flat surface comprising a group of Si single crystals and a group of silicon oxide film areas is observed.

### Example 2

First, using a Si (100) wafer substrate as a base material, a silicon dioxide film with a film thickness of about 100 nm (1000 Å) is formed by thermal oxidation.

On the silicon dioxide film is deposited an amorphous silicon (hereinafter abbreviated as a-Si) film by a conventional reduced pressure CVD method using SiH₄ gas under the growth conditions of a substrate temperature of 560oC and a pressure of 40 Pa (0.3 Torr) to a thickness of 100 nm (1000 Å). When the deposited film is examined by X-ray diffraction, it is confirmed to be completely amorphous. Then, phosphorus is doped into the a-Si film as an impurity at a concentration of 7.5 x 10²⁰ cm⁻³ by thermal diffusion by using POCl₃.

Next, using a conventional resist process, the doped a-Si film is patterned with square shapes with each side of 2 µm length at lattice points at intervals of 80 µm, and the remainder is removed so that a surface of the silicon dioxide film is exposed. Etching is by the RIE method (reaction ion etching) and removes unnecessary portions of the doped a-Si film, thereby forming areas of a-Si (P) films 102a, 102b, 102c... which are to be the nucleation surfaces.

Further, the areas of a-Si films which are formed finely are annealed in an N₂ atmosphere at a temperature of 950^{o}C and for a time of 20 minutes. It is in fact sufficient that the annealing temperature is 800^{o}C or higher. After annealing, examination by X-ray diffraction reveals that all of the areas of a-Si (P) film are formed into single crystals with a regular face orientation in the 〈111〉 direction (single crystalline Si (P) film). This phenomenon is also known in Y. Wada and S. Nishimatsu, J. Electrochem. Soc. 125, 1499 (1978) and others, and called "Abnormal grain growth".

On a substrate having a large number of single crystalline Si (P) films formed at predetermined positions on the surface, a silicon dioxide film is deposited to 500 nm (5000 Å) by a conventional CVD method. The silicon dioxide film is patterned by a conventional resist process so that squares with sides of 10 µm are arranged at the centre of a square (each side :80 µm) with the positions of areas of single crystalline Si (P) arranged at four lattice points as the apexes so as to be slanted at 45^{o} relative to the square. RIE etching is used to remove surplus portions of the silicon dioxide film, thereby forming void generation preventive bodies (areas of silicon dioxide film) 103a, 103b, 103c...

On the substrate having thus void generation preventive bodies 103a, 103b, 103c... formed thereon, Si is deposited by CVD method under the following deposition conditions.
Gases used (flow rate ratio): SiH₂Cl₂/HCl/H₂= 0.53/1.7/100.0 (1/min)
Substrate temperature and pressure: 1000^{o}C. 2.00 x 10⁴ Pa (150 Torr)
Deposition time: 90 min.

As a result, with the centres of all the nucleation surfaces arranged at lattice points as the crystal growth origination points, Si single crystals with a grain size of about 80 µm are grown, which contact the single crystals grown from the adjacent nucleation surfaces to form a grain boundary. Further, the Si single crystals also contact the silicon dioxide films and the Si single crystals are found to be grown up to the surface of the silicon dioxide films at many places. As a result of observation by an optical microscope, all the surfaces are found to be covered with Si single crystals and areas of silicon dioxide film. Further, when polishing is effected on the surface portions of the respective Si single crystals by a selective polishing method similarly as in Example 1, polishing is completed with the silicon dioxide films as etch stop. When the substrate thus treated is again subjected to surface observation by an optical microscope, a flat surface comprising a group of Si single crystals and a group of silicon oxide film areas is observed.

By prior arrangement of void generation preventive bodies to fill potential void areas which otherwise would arise at gaps between single crystals formed, generation of voids can be inhibited. These otherwise would cause problems such as step cutting or wiring, etc. in forming semiconductor integrated circuits in the single crystal group after the flattening treatment or other electrical, optical elements and become troublesome with respect to circuit constitution and yield.

By comparison with the prior art, since there is no void which is readily formed the degree of freedom is higher in design and construction and thus even further higher densification in forming semiconductor integrated circuits or other electronic, optical elements becomes achievable.

## Claims

1. A method for forming a plurality of single-crystals on a substrate, which method comprises the steps of:
providing a substrate (201), having a plurality of nucleation surfaces (102a,b,c) which serve as crystal growth origination points, and a non-nucleation surface (101) having a nucleation density smaller than the nucleation density of the nucleation surfaces (102a,b,c); and
applying to the substrate (201) a crystal growth treatment for a time long enough for adjacent crystals (104a,b) which are grown from the crystal growth origination points (102a,b,c) to contact each other,
which method is characterised in that
at a predetermined position of a void (305) which otherwise would be formed between said single-crystals (104a,b), a void generation preventive body (103a,b,c) for filling said void (305) is prearranged, the surface of which has a nucleation density which is smaller by at least 10² fold than the nucleation density of each nucleation surface (102a,b,c).

2. A method according to claim 1, wherein said crystal growth treatment is a gas phase method or a liquid phase method.

3. A method according to claims 1 or 2, wherein said void generation preventive body is of insulating material.

4. A method according to any of claims 1 to 3, wherein said void generation preventive body comprises a material selected from silicon dioxide, tin oxide, indium oxide, silicon nitride and non-stoichiometric compound variants thereof.

5. A method according to claim 1, wherein said void generation preventive body is substantially of square shape in plan view.

6. A method according to claim 1, wherein said void generation preventive body is formed by chemical vapour deposition.

7. A method according to any preceding claim wherein said crystals are flattened by etching or polishing at least down to the level of said void generation preventive body thereby to produce a flattened and continuous surface.

## Patentansprüche

1. Verfahren zur Bildung einer Vielzahl von Einkristallen auf einem Substrat, wobei das Verfahren folgende Schritte umfaßt:
Bereitstellung eines Substrates (201) mit einer Vielzahl von Keimbildungsoberflächen (102a, b, c), die als Ausgangspunkte für Kristallwachstum dienen, und einer nicht-keimbildende Oberfläche (101), die eine Keimbildungsdichte besitzt, die kleiner ist als die Keimbildungsdichte der Keimbildungsoberflächen (102a, b, c); und
Anwendung einer Kristallzüchtungsbehandlung auf das Substrat (201) für einen Zeitraum, der groß genug ist, daß benachbarten Kristalle (104a, b), die von den Ausgangspunkten (102a, b, c) des Kristallwachstums her wachsen, einander berühren,
wobei das Verfahren dadurch gekennzeichnet ist, daß an einer vorbestimmten Position einer Leerstelle (305), die sich sonst zwischen den Einkristallen (104a, b) bilden wurde, vorher ein die Erzeugung von Leerstellen verhindernder Körper (103a, b, c) angeordnet wird, um die genannte Leerstelle (305) zu fallen, dessen Oberfläche eine Keimbildungsdichte hat, die mindestens 100-mal kleiner ist als die Keimbildungsdichte jeder Keimbildungsoberfläche (102a, b, c).

2. Verfahren nach Anspruch 1, worin die Kristallzüchtungsbehandlung ein Gasphasenverfahren oder ein Flüssigphasenverfahren ist.

3. Verfahren nach den Ansprüchen 1 oder 2, worin der die Erzeugung von Leerstellen verhindernde Körper aus isolierendem Material besteht.

4. Verfahren nach einem der Ansprüche 1 bis 3, worin der die Erzeugung von Leerstellen verhindernde Körper ein Material umfaßt, das ausgewählt ist aus Siliciumdioxid, Zinnoxid, Indiumoxid, Siliciumnitrid und deren nichtstöchiometrischen Verbindungsvariationen

5. Verfahren nach Anspruch 1, worin der die Erzeugung von Leerstellen verhindernde Körper in der Draufsicht im wesentlichen quadratische Gestalt hat.

6. Verfahren nach Anspruch 1, worin der die Erzeugung von Leerstellen verhindernde Körper im wesentlichen durch chemisches Aufdampfen (CVD) gebildet wird.

7. Verfahren nach einem der vorhergehenden Ansprüche, worin die genannten Kristalle durch Ätzen oder Polieren geglättet werden und zwar mindestens bis auf die Höhe des die Erzeugung von Leerstellen verhindernden Körpers herunter, um dadurch eine geglättete und durchgehende Oberfläche zu erzeugen.

## Revendications

1. Procédé pour former un ensemble de monocristaux sur un substrat, ce procédé comprenant les étapes consistant à:
utiliser un substrat (201) ayant un ensemble de surfaces de nucléation (102a,b,c) qui jouent le rôle de points d'origine de la croissance cristalline, et une surface (101) ne provoquant pas de nucléation ayant une densité de nucléation inférieure à la densité de nucléation des surfaces de nucléation (102a,b,c); et
appliquer au substrat (201) un traitement de croissance cristalline pendant un temps suffisamment long pour que des cristaux adjacents (104a,b) qui croissent à partir des points d'origine de croissance cristalline (102a,b,c), viennent au contact les uns des autres, ce procédé étant caractérisé en ce que
en une position prédéterminée d'un vide (305) qui se formerait par ailleurs entre lesdits monocristaux (104a, b), un corps (103a,b,c) empêchant la formation de vides destiné à remplir ledit vide (305) est préalablement disposé, sa surface ayant une densité de nucléation inférieure d'un facteur au moins égal à 10² à la densité de nucléation de chaque surface de nucléation (102a,b,c).

2. Procédé selon la revendication 1, dans lequel ledit traitement de croissance cristalline est un procédé en phase gazeuse ou un procédé en phase liquide.

3. Procédé selon les revendications 1 ou 2, dans lequel ledit corps empêchant la formation de vides est constitué d'un matériau isolant.

4. Procédé selon l'une quelconque des revendications 1 à 3, dans lequel ledit corps empêchant la formation de vides comprend un matériau sélectionné parmi le dioxyde de silicium, l'oxyde d'étain, l'oxyde d'indium, le nitrure de silicium, et des composés non stoechiométriques dérivés de ceux-ci.

5. Procédé selon la revendication 1, dans lequel ledit corps empêchant la formation de vides présente une forme sensiblement carrée en vue plane.

6. Procédé selon la revendication 1, dans lequel ledit corps empêchant la formation de vides est formé par dépôt chimique en phase vapeur.

7. Procédé selon l'une quelconque des revendications précédentes, dans lequel lesdits cristaux sont aplanis par attaque ou polissage, au moins jusqu'au niveau dudit corps empêchant la formation de vides afin de produire une surface aplanie et continue.
